# EUROPÄISCHE PATENTSCHRIFT

(11) **EP 1 203 396 B1**
(45) Veröffentlichungstag und Bekanntmachung des Hinweises auf die Patenterteilung: **08.11.2006**
(21) Anmeldenummer: 00949075.6
(22) Anmeldetag: 06.06.2000
(51) Int. Cl.: H01J 37/32, H01L 21/3065

(54) **VERFAHREN ZUM ÄTZEN EINES SUBSTRATES MITTELS EINES INDUKTIV GEKOPPELTEN PLASMAS**
METHOD FOR ETCHING A SUBSTRATE USING AN INDUCTIVELY COUPLED PLASMA
PROCEDE DE GRAVURE D'UN SUBSTRAT AU MOYEN D'UN PLASMA INDUCTIF

(30) Priorität: 20.07.1999 DE 19933841
(43) Veröffentlichungstag der Anmeldung: 08.05.2002
(73) Patentinhaber: ROBERT BOSCH GMBH, 70442 Stuttgart (DE)
(72) Erfinder: BECKER, Volker, D-76359 Marxzell (DE); LAERMER, Franz, D-70437 Stuttgart (DE); SCHILP, Andrea, D-73525 Schwaebisch Gmuend (DE)
(86) Internationale Anmeldenummer: PCT/DE2000/001836
(87) Internationale Veröffentlichungsnummer: WO 2001/006540

(56) Entgegenhaltungen:
- EP-A- 0 849 766
- WO-A-97/14177
- WO-A-99/50883
- WO-A1-00/36631
- US-A- 5 648 701
- US-A- 5 669 975
- US-A- 5 824 604
- US-A- 5 824 606
- PATENT ABSTRACTS OF JAPAN vol. 1998, no. 08, 30. Juni 1998 (1998-06-30) & JP 10 064696 A (TOKYO ELECTRON LTD), 6. März 1998 (1998-03-06) & US 5 997 687 A (KOSHIMIZU CHISIO) 7. Dezember 1999 (1999-12-07)

## Beschreibung

Die Erfindung betrifft ein Verfahren zum Ätzen eines Substrates, insbesondere eines Siliziumkörpers, mittels eines induktiv gekoppelten Plasmas nach dem Oberbegriff des Anspruchs 1.

### Stand der Technik

Um ein anisotropes Hochratenätzenverfahren beispielsweise für Silizium unter Einsatz einer induktiven Plasmaquelle zu realisieren, ist es bei einem Verfahren, wie es beispielsweise aus DE 42 41 045 C2 bekannt ist, erforderlich, in möglichst kurzer Zeit eine effiziente Seitenwandpassivierung während sogenannter Passivierschritte durchzuführen und ferner eine möglichst hohe Konzentration von Silizium ätzenden Fluorradikalen während sogenannter Ätzschritte zu erreichen. Um dabei eine möglichst hohe Ätzrate zu erreichen, ist es naheliegend, mit möglichst hohen Hochfrequenzleistungen an der induktiven Plasmaquelle zu arbeiten und dadurch möglichst hohe Plasmaleistungen in das erzeugte induktiv gekoppelte Plasma einzukoppeln.

Diesen Hochfrequenzleistungen sind jedoch Grenzen gesetzt, die sich einerseits aus der Belastbarkeit der elektrischen Komponenten der Plasmaquelle ergeben, andererseits aber auch prozeßtechnischer Natur sind. So verstärken hohe Hochfrequenzleistungen der induktiven Plasmaquelle schädliche elektrische Eingriffe aus dem Quellenbereich in das erzeugte induktiv gekoppelte Plasma, die die Ätzergebnisse auf dem Substratwafer verschlechtern.

Zudem treten bei Ätzprozessen nach Art der DE 42 41 045 C2 Stabilitätsprobleme bei der Plasmaeinkopplung in den Umschaltphasen zwischen Ätz- und Passivierschritten auf. Dies beruht darauf, daß sich bei hohen einzukoppelnden Leistungen im kWatt-Bereich während der Umschaltphasen auftretende Leistungsreflektionen und Spannungsüberhöhungen zerstörerisch im elektrischen Kreis der Plasmaquelle (Spule, angeschlossene Kapazitäten, Generatorendstufe) auswirken können.

In der Anmeldung DE 199 00 179 ist dazu bereits eine gegenüber der DE 42 41 045 C2 weiterentwickelte induktive Plasmaquelle beschrieben, die mittels einer verlustfreien symmetrischen Hochfrequenzspeisung der Spule der induktiven Plasmaquelle für besonders hohe Plasmaleistungen geeignet ist, und die ein induktives Plasma generiert, welches besonders arm an elektrischen Störeinkopplungen ist. Doch auch für diesen Quellentyp existiert eine praktikable Leistungsgrenze von etwa 3 kWatt bis 5 kWatt, oberhalb der die benötigten Hochfrequenzkomponenten extrem teuer werden oder die Probleme hinsichtlich der Plasmastabilität überhand nehmen.

Ein möglicher Ansatz um innerhalb eines handhabbaren Leistungsrahmens zu höheren Ätzraten zu kommen, ist die Steigerung der Effizienz der Plasmaerzeugung. In diesem Zusammenhang ist der Einsatz von Magnetfeldern zur Erhöhung der Plasmaeffizienz aus dem Stand der Technik grundsätzlich bekannt.

Durch Anlegen eines Magnetfelds an ein Plasma werden bekanntermaßen die Elektronenbahnen im Plasma gekrümmt und dadurch die Verweildauer der Elektronen im Plasma, d.h. die Zeit bis zum Erreichen einer Wandung, welche die Elektronen absorbiert, erhöht, so daß jedes Elektron bis zum Verlassen des effektiven Plasmaerregungsbereiches öfter mit umgebenden Gasatomen wechselwirken kann. Solche Stoßwechselwirkungen zwischen Elektronen und Gasmolekülen führen zur gewünschten Ionisation oder Dissoziation der Gasmoleküle unter Freisetzung der für den Ätzprozeß benötigten Radikale.

Ein sogenanntes magnetisches "Multipol-Confinement" besteht nach dem Stand der Technik aus einer metallischen, nicht ferromagnetischen Wandung mit einer Vielzahl von Permanentmagneten abwechselnder Polarität, die durch Magnetfelder Elektronen von der mit diesen Magneten ausgestatteten Wandung reflektieren. Dadurch kann eine höhere Elektronendichte innerhalb dieses "Multipol-Confinements" erzeugt werden. Eine entsprechende RIE-Quelle ("Reactive Ion Etching") wird beispielsweise von der Firma TEGAL Corporation, Petaluma, CA 94955-6020, USA als sogenannte _{"}HRe⁻-Quelle" vertrieben.

Andere bekannte Plasmaquellentypen bedienen sich weiter eines Magnetfelds mit Feldrichtung parallel zu einer Substratelektrode. Unmittelbar an der Substratelektrode wird so durch eine Art Helmholtz-Spulenpaar eine möglichst homogene Feldverteilung erzeugt, die dort zu einer Verlängerung der Elektronenbahnen und damit zur Erzeugung höherer Plasmadichten führt. Zur weiteren Homogenisierung der Effekte kann dieses horizontal orientierte Magnetfeld wie beispielsweise in den MRIE-Anlagen ( _{"}Magnetically Enhanced Reactive Ion Etching") der Firma Applied Materials Inc., Santa Clara, CA 95054-3299, USA weiter langsam in der Ebene rotiert werden.

Im Fall von sogenannten ECR-Quellen (Electron Cyclotron Resonance) ist weiter bereits bekannt, ein longitudinales Magnetfeld so abzustimmen, daß die Umlauffrequenz der Elektronen in diesem Magnetfeld, die sogenannte Cyclotronfrequenz, zumindest in einem gewissen Volumenbereich des Ätzreaktors resonant zur Frequenz einer eingekoppelten Mikrowellenstrahlung ist. Somit kann bei ausreichender freier Weglänge der Elektronen eine besonders effiziente Plasmaanregung durch die Mikrowelleneinstrahlung erfolgen, was solchen ECR-Quellen den Niederdruckbereich mit Prozeßdrücken kleiner 1 µbar als Anwendungsfeld erschließt. Der niedrige Druck ist dabei notwendige Voraussetzung für eine ausreichend große freie Weglänge der Elektronen und für eine effiziente Plasmaanregung. Bei höheren Drücken werden ECR-Quellen rasch ineffizient und gehen über in eine unerwünschte thermische Plasmageneration. Der Vorteil des magnetischen Einschlusses und der resonanten Erregung gehen dabei weitgehend verloren.

Aus der Formel für die Cyclotronfrequenz ω=eB/m folgt B=mω/e, d.h. bei der üblicherweise eingestrahlten Mikrowellenfrequenz von 2.45 GHz liegt die für Cyclotronresonanz benötigte Magnetfeldstärke bei 87.6 mTesla.

Auf den Fall der Hochfrequenzanregung im MHz-Bereich d.h. im Fall typischer Frequenzen für ICP-Quellen ("Inductively Coupled Plasma") ist diese Applikation nicht ohne weiteres übertragbar, da die hierfür erforderlichen freien Weglängen der Elektronen extrem niedrige, unpraktikable Drücke voraussetzen. Schließlich muß eine induktive Plasmaquelle für Hochratenätzverfahren für einen relativ hohen Druckbereich von ca. 30 bis 100 µbar konfiguriert sein.

Die für die induktive Plasmaanregung mit ICP-Quellen üblicherweise eingesetzte Hochfrequenz von 13.56 MHz würde weiter im Fall der Cyclotronresonanz eine Resonanzfeldstärke von nur 0.5 mT implizieren. Ein derart geringes Feld weist jedoch kaum noch eine Führungsfunktion für die Elektronen auf. Für eine ausreichende Führungsfunktion, d.h. eine Unterdrückung der Wandverluste der Elektronen in einem ausgedehnten Plasmavolumen werden Feldstärken von 10 mTesla oder besser einigen 10 mTesla bis 100 mTesla benötigt.

Magnetspulen in einer ECR-artigen Konfiguration werden weiter üblicherweise oberhalb oder auf Höhe der Plasmaquelle plaziert, um unmittelbar am Ort der Plasmaerzeugung die höchste Feldstärke zu generieren und dort den größtmöglichen Einfluß auf den Plasmaerzeugungsmechanismus zu nehmen. In Richtung auf das zu ätzende Substrat nimmt die magnetische Feldstärke dann durch die Divergenz des Magnetfelds rasch ab, so daß die Führungsfunktion des Magnetfelds in einer derartigen Anordnung dort nicht mehr ausreichend gegeben ist.

Aus der Anmeldung DE 199 198 32 ist weiter bereits bekannt, die in ein induktiv gekoppeltes Plasma mit einem hochfrequenten elektromagnetischen Wechselfeld eingekoppelte Plasmaleistung adiabatisch zwischen einzelnen Verfahrensschritten, insbesondere alternierenden Ätz- und Passivierschritten, zu variieren. Ein derartiger adiabatischer Leistungsübergang d.h. ein allmähliches Hochfahren bzw. Verringern der eingekoppelten Plasmaleistung bei gleichzeitiger kontinuierlicher Anpassung der Impedanz der ICP-Quelle an die jeweilige, von der eingekoppelten Plasmaleistung abhängige Plasmaimpedanz mittels eines automatischen Anpaßnetzwerkes oder eines Impedanztransformators ("Matchbox") ermöglicht es, die erläuterten Probleme hinsichtlich Leistungsreflexion und Spannungsüberhöhung beim Ein- und Ausschalten von Plasmaleistungen im Bereich von 1 kWatt bis 5 kWatt zu beherrschen. Eine typische Zeitdauer der Einschaltvorgänge liegt dabei jedoch im Bereich von 0,1 sec bis 2 sec. Schnelle Leistungsänderungen sind nach diesem Ansatz daher nicht möglich.

Weiter ist aus EP 0 849 766 A2 eine Vorrichtung und ein Verfahren zum Ätzen eines Siliziumsubstrates mittels eines indduktiv gekoppelten RF Plasmas bekannt, bei welchen eine Magnetfeldspule oder ein Permanentmagnet zwischen dem Substrat und einer IPC-Quelle ein statisches Magnetfeld erzeugt. Ähnlich wird in US 5,648,701 A ein Plasma-Reaktor beschrieben, bei dem mittels einer IPC-Quelle im Reaktor ein induktiv gekoppeltes RF Plasma und mittels eines zusätzlichen Magnetfelderzeuger zwischen einem Substrat und der IPC-Quelle ein statisches oder ein zeitlich variierendes Magnetfeld erzeugt werden. Dieser Reaktor ist zum chemischen Prozessieren von Substraten vorgesehen. Schließlich wird auch in WO 99/50883 A ein Reaktor mit einer IPC-Quelle vorgestellt, mit dem ein Ätzvorgang eines Substrates durchgeführt werden kann. Dabei wird im Reaktor gleichzeitig ein Magnetfeld erzeugt.

### Vorteile der Erfindung

Mit dem erfindungsgemäßen Verfahren gemäß Anspruch 1 ist ein Ätzvorgang eines Substrates möglich, wobei bei dem Ätzen ein zeitlich variierendes Magnetfeld erzeugt und vorteilhafterweise das Pulsen des Magnetfeldes mit dem Pulsen der eingekoppelten Plasmaleistung und/oder dem Pulsen der in das Substrat eingekoppleten Hochfrequenzleistung zeitlich korreliert oder synchronisiert wird.

Vorteilhafte Weiterbildungen der Erfindung ergeben sich aus den in den Unteransprüchen genannten Maßnahmen.

### Zeichnungen

Ausführungsbeispiele der Erfindung werden anhand der Zeichnungen und in der nachfolgenden Beschreibung näher erläutert. Es zeigt Figur 1 eine stark schematisierte Plasmaätzanlage, Figur 2 eine elektronische Rückkopplungsschaltung mit angeschlossener ICP-Quelle, Figur 3 ein Beispiel für eine Filterkennlinie und Figur 4 ein Beispiel für eine zeitliche Korrelation von Hochfrequenzleistungspulsen und Magnetfeldpulsen.

### Ausführungsbeispiele

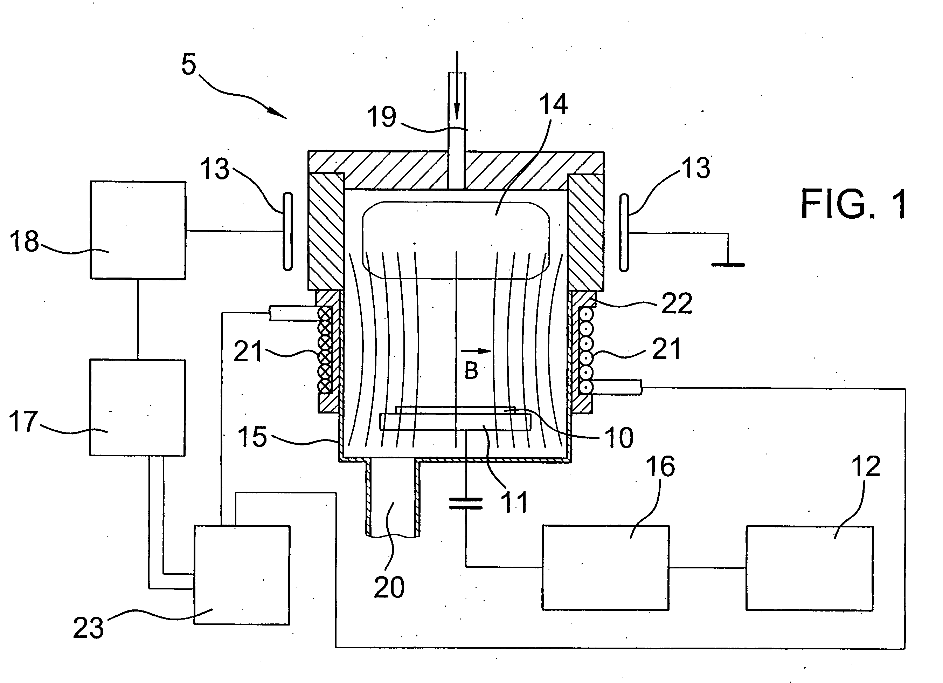

Eine Vorrichtung zur Durchführung der Erfindung wird anhand der Figur 1 näher erläutert. Eine Plasmaätzanlage 5 weist dazu zunächst einen Reaktor 15 auf, in dessen oberem Bereich in an sich bekannter Weise über eine ICP-Quelle 13 ("Inductively Coupled Plasma") ein induktiv gekoppeltes Plasma 14 erzeugt wird. Weiterhin ist eine Gaszufuhr 19 zur Zufuhr eines Reaktivgases wie beispielsweise SF₆, ClF₃, O₂, C₄F₈, C₃F₆, SiF₄ oder NF₃, eine Gasabfuhr 20 zur Abfuhr von Reaktionsprodukten, ein Substrat 10, beispielsweise ein mit dem erfindungsgemäßen Ätzverfahren zu strukturierender Siliziumkörper oder Siliziumwafer, eine mit dem Substrat 10 in Kontakt befindliche Substratelektrode 11, ein Substratspannungsgenerator 12 und ein erster Impedanztransformator 16 vorgesehen. Der Substratspannungsgenerator 12 koppelt dabei in die Substratelektrode 11 und darüber in das Substrat 10 eine hochfrequente Wechselspannung oder Hochfrequenzleistung ein, die eine Beschleunigung von in dem induktiv gekoppelten Plasma 14 erzeugten Ionen auf das Substrat 10 bewirkt. Die darüber eingekoppelte Hochfrequenzleistung bzw. Wechselspannung liegt typischerweise zwischen 3 Watt und 50 Watt bzw. 5 Volt und 100 Volt im Dauerstrichbetrieb bzw. bei gepulstem Betrieb jeweils im Zeitmittel über die Pulssequenz.

Weiterhin ist ein ICP-Spulengenerator 17 vorgesehen, der mit einem zweiten Impedanztransformator 18 und darüber mit der ICP-Quelle 13 in Verbindung steht. Somit generiert die ICP-Quelle ein hochfrequentes elektromagnetisches Wechselfeld und darüber in dem Reaktor 15 ein induktiv gekoppeltes Plasma 14 aus Reaktiven Teilchen und elektrisch geladenen Teilchen (Ionen), die durch Einwirken des hochfrequenten elektromagnetischen Wechselfeldes auf das Reaktivgas entstehen. Die ICP-Quelle 13 weist dazu eine Spule mit mindestens einer Windung auf.

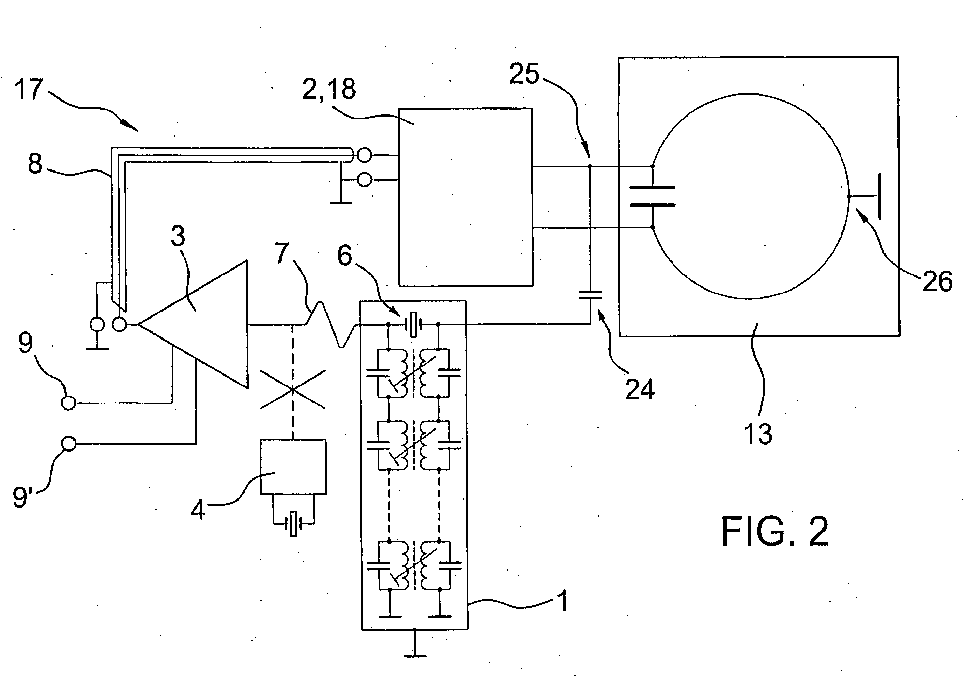

Der zweite Impedanztransformator 18 ist weiter bevorzugt in der in der Anmeldung DE 199 00 179 vorgeschlagenen Weise ausgeführt, so daß eine balancierte, symmetrisch aufgebaute Konfiguration und Speisung der ICP-Quelle 13 über den ICP-Spulengenerator 17 gegeben ist. Damit wird insbesondere gewährleistet, daß die an den beiden Enden der Spule der ICP-Quelle 13 anliegenden hochfrequenten Wechselspannungen zumindest nahezu gegenphasig zueinander sind. Weiter ist der Mittelabgriff der Spule der ICP-Quelle, wie in Figur 2 angedeutet, bevorzugt geerdet.

Mit der Plasmaätzanlage 5 wird weiter beispielsweise der aus DE 42 41 045 C2 bekannte anisotrope Hochratenätzprozeß für Silizium mit alternierenden Ätz- und Passivierschritten durchgeführt. Hinsichtlich weiterer, dem Fachmann an sich bekannter Details zu der Plasmaätzanlage 5, die insoweit als bisher beschrieben aus dem Stand der Technik bekannt ist, und des damit durchgeführten Ätzverfahrens, insbesondere hinsichtlich der Reaktivgase, der Prozeßdrücke und der Substratelektrodenspannungen in den jeweiligen Ätzschritten bzw. Passivierschritten sei daher auf die DE 42 41 045 C2 verwiesen.

Die Plasmaätzanlage 5 ist im übrigen auch geeignet für eine Prozeßführung, wie sie in der Anmeldung DE 199 27 806.7 beschrieben ist.

Insbesondere wird beim Ätzen des Substrates 10 während der Passivierschritte in dem Reaktor 15 mit einem Prozeßdruck von 5 µbar bis 20 µbar und mit einer über die ICP-Quelle 13 in das Plasma 14 eingekoppelten Plasmaleistung von 300 bis 1000 Watt passiviert. Als Passiviergas eignet sich beispielsweise C₄F₈ oder C₃F₆. Während der nachfolgenden Ätzschritte wird dann ein Prozeßdruck von 30 µbar bis 50 µbar und einer hohen Plasmaleistung von 1000 bis 5000 Watt geätzt. Als Reaktivgas eignet sich beispielsweise SF₆ oder ClF₃.

Eine bevorzugte Ausgestaltung der Plasmaätzanlage 5 sieht weiter vor, daß zur Verbesserung der Selektivität eines Ätzgrundpolymerabtrags relativ zum Seitenwandfilmabtrag die über den Substratspannungsgenerator 12 an dem Substrat 10 anliegende Ionenbeschleunigungsspannung durch Reduktion der eingekoppelten Plasmaleistung in den Ätzschritten jedesmal nach Durchbruch des initialen Ätzgrundpolymers zurückgeschaltet wird, wie dies in der Anmeldung DE 199 19 832 bereits vorgeschlagen und im Detail erläutert wurde.

Dieses Zurückschalten erfolgt dabei in an sich bekannter Weise entweder schlagartig oder aber kontinuierlich über eine zeitliche Rampenfunktion. Damit wird eine weitere Verbesserung der Siliziumätzrate, der Selektivität des Ätzprozesses gegenüber einem Maskenmaterial, der Profiltreue und beispielsweise eine Unterdrückung von Taschen an einer dielektrischen Ätzstopschicht erreicht.

Zusätzlich ist zwischen dem induktiv gekoppelten Plasma 14 bzw. der ICP-Quelle 13, d.h. der eigentlichen Plasmaerregungszone, und dem Substrat 10 weiter ein sogenannter "Spacer" als Distanzstück 22 aus einem nichtferromagnetischen Material wie beispielsweise Aluminium plaziert. Dieses Distanzstück 22 ist in die Wand des Reaktors 15 konzentrisch als Distanzring eingesetzt und bildet somit bereichsweise die Reaktorwand. Er hat eine typische Höhe von ca. 5 mm bis 30 mm bei einem typischen Durchmesser des Reaktors 15 von 30 cm bis 100 cm.

Das Distanzstück 22 umgibt weiter eine Magnetfeldspule 21, die beispielsweise 100 bis 300 Windungen aufweist und aus einem für die einzusetzende Stromstärke ausreichend dick bemessenen Kupferlackdraht gewickelt ist. Zusätzlich können Kupferrohre mit in die Magnetfeldspule 21 aufgenommen werden, durch die Kühlwasser strömt, um Wärmeverluste aus der Magnetfeldspule 21 abzuführen.

Es ist alternativ auch möglich, die Magnetfeldspule 21 selbst aus einem dünnen, mit einem elektrisch isolierenden Material lackierten Kupferrohr zu wickeln, welches direkt von Kühlwasser durchströmt wird.

Durch die Magnetfeldspule 21 wird weiter über eine Stromversorgungseinheit 23 ein elektrischer Strom von beispielsweise 10 bis 100 Ampere geleitet.

Im erläuterten Beispiel ist dies beispielsweise ein Gleichstrom, der im Inneren des Reaktors 15 ein statisches Magnetfeld erzeugt, das im Fall einer Magnetfeldspule 21 mit 100 Windungen und einer Länge von 10 cm sowie einem Durchmesser von 40 cm beispielsweise eine magnetische Feldstärke im Zentrum der Magnetfeldspule 21 von etwa 0,3 mTesla/A Stromfluß erzeugt.

Für eine signifikante Steigerung der Plasmaerzeugungseffizienz und einer ausreichenden magnetischen Führung des induktiv gekoppelten Plasma 14 werden, wie bereits beschrieben, 10 mT bis 100 mT, beispielsweise 30 mT benötigt. Das bedeutet, die Stromversorgungseinheit 23 stellt während des Ätzens eines Substrates 10 mit der Plasmaätzanlage 5 Stromstärken von etwa 30 bis 100 Ampere bereit.

In jedem Fall ist wichtig, daß die Richtung des über die Magnetfeldspule 21 oder den Permanentmagneten erzeugten Magnetfeldes zumindest näherungsweise oder überwiegend parallel zu der durch die Verbindungslinie von Substrat 10 und induktiv gekoppeltem Plasma 14 bzw. der Plasmaerregungszone definierten Richtung ist (longitudinale Magnetfeldorientierung).

Eine vorteilhafte Ausgestaltung sieht weiter vor, daß zur Uniformitätsverbesserung des Ätzprozesses eine aus der DE 197 34 278 bekannte Apertur angebracht wird. Diese Apertur ist in Figur 1 aus Gründen der Übersichtlichkeit nicht dargestellt. Sie ist im Inneren des Reaktors 15 konzentrisch zur Reaktorwand zwischen der ICP-Quelle 13 bzw. der Plasmaerregungszone und dem Substrat 10 angebracht. Bevorzugt ist sie ca. 5 cm oberhalb der Substratelektrode 11 oder des Substrates 10 an dem Distanzstück 22 ("Spacer") befestigt.

Zudem muß im Falle der Verwendung einer Magnetfeldspule 21 in die Stromversorgungseinheit 23 eine geeignete, an sich bekannte Überwachungsvorrichtung integriert sein, die in die Prozeßablaufsteuerung eingebunden ist und eine Überwachung der Spulentemperatur und eine Notabschaltung beispielsweise bei Kühlwasserausfall vornimmt.

Es ist vorteilhaft, daß mit dem IPC-Spulengenerator eine mit der ICP-Quelle (13) in das induktiv gekoppelte Plasma (14) über das hochfrequente elektromagnetische Wechselfeld eingekoppelte Plasmaleistung einstellbar ist, und zur Anpassung einer Ausgangsimpedanz des ICP-Spulengenerators (17) an eine von der eingekoppelten Plasmaleistung abhängige Plasmaimpedanz ein zweiter Impedanztransformator (18) in Form eines insbesondere balancierten und symmetrischen Anpaßnetzwerkes vorgesehen ist.

Das bevorzugt symmetrisch aufgebaute und die ICP-Quelle 13 symmetrisch speisende Anpaßnetzwerk in dem zweiten Impedanztransformator 18 ist dabei bevorzugt so eingestellt, daß es eine optimale Impedanzanpassung im stationären Leistungsfall gewährleistet. Dieser stationäre Leistungsfall ist dadurch gekennzeichnet, daß dabei die induktiv in das Plasma 14 eingekoppelte Plasmaleistung einen hohen Maximal- oder Endwert von beispielsweise 3000 Watt bis 5000 Watt erreicht hat, wobei gleichzeitig eine Stationär- oder Resonanzfrequenz 1" von beispielsweise 13,56 MHz der von dem ICP-Spulengenerator 17 erzeugten Frequenz des hochfrequenten elektromagnetischen Wechselfelds erreicht ist.

Die Stationärfrequenz 1" üblicher ICP-Spulengeneratoren 17 beträgt im allgemeinen 13,56 MHz, wobei neben diesem Standard auch Generatoren mit anderen Frequenzen oder Frequenzbereichen kommerziell erhältlich sind. In derartigen ICP-Spulengeneratoren 17 ist jedoch abweichend von der erfindungsgemäßen Realisierung die Stationärfrequenz 1" auf einen festen Wert eingestellt und dazu beispielsweise aus der Eigenfrequenz eines Schwingquarzes mit großer Genauigkeit abgeleitet. Damit ist während einer Leistungsänderung, beispielsweise dem Hochfahren der in das Plasma 14 einzukoppelnden Plasmaleistung von beispielsweise 500 Watt auf 3000 Watt, bei fester Frequenz des vom ICP-Spulengenerator 17 erzeugten hochfrequenten Wechselfeldes mit einer vorgegebenen Einstellung des Impedanztransformators 17 keine oder nur eine schlechte Anpassung an die sich als Funktion der Plasmaleistung verändernde Plasmaimpedanz möglich, so daß hohe reflektierte Leistungen während der Transienten auftreten. Wird jedoch in solchen Phasen die Frequenz des ICP-Spulengenerators 17 freigegeben, so kann durch eine Änderung der Frequenz des hochfrequenten elektromagnetischen Wechselfeldes stets eine weitgehend optimale Impedanzanpassung auch unter sich schnell verändernden Plasmabedingungen aufrechterhalten werden.

Der wesentliche Vorteil einer Herstellung der korrekten Impedanzanpassung über eine variable Frequenz der Hochfrequenzleistung des ICP-Spulengenerators 17 liegt darin, daß diese Frequenzänderung sehr schnell durchgeführt werden kann, da sie nur durch die Regelgeschwindigkeit der entsprechenden elektronischen Schaltung begrenzt ist. So sind Reaktionszeiten im Mikrosekundenbereich ohne weiteres möglich.

Im Gegensatz dazu erfordert die manuelle oder automatische Einstellung eines Anpaßnetzwerks in dem zweiten Impedanztransformator 18 die Änderung mechanischer Größen, beispielsweise das Verstellen von Drehkondensatoren durch Motoren, was entsprechend langsam vonstatten geht. Typische Zeitkonstanten liegen hier im Bereich von Zehntelsekunden.

In bevorzugter Ausgestaltung des Ausführungsbeispiels detektiert eine beispielsweise in dem zweiten Impedanztransformator 18 integrierte Regelschaltung in an sich bekannter Weise den momentanen Regelfehler, d.h. die Fehlanpassung zwischen der Impedanz des Ausgangs des ICP-Spulengenerators 17 und der Impedanz der ICP-Quelle 13 hinsichtlich Amplitude und Phase. Dies geschieht bevorzugt über eine Messung des an der ICP-Quelle 13 bzw. dem zweiten Impedanztransformator 18 reflektierten Signals mit aus der Hochfrequenztechnik hinlänglich bekannten Reflektometern, wobei Amplitude und Phasenfehler detektiert werden.

Aus dieser Information wird dann bevorzugt kontinuierlich innerhalb eines vorgegebenen Frequenzbereichs eine entsprechende, jeweils erforderliche Frequenzveränderung des elektromagnetischen Wechselfeldes am ICP-Spulengenerator 17 ermittelt, so daß der Regelfehler hinsichtlich Amplitude und Phase minimiert wird. Im wesentlichen wird dabei lediglich ein Amplitudenfehler ausgeregelt, da sich bekanntermaßen weitgehend nur der reelle Plasmawiderstand als Funktion der eingekoppelten Plasmaleistung verändert und die Phasenbeziehung der Impedanzen bereits durch erläuterte Voreinstellung des zweiten Impedanztransformators 18 zumindest grob richtig eingestellt ist.

Wird die Ausgangsleistung des ICP-Spulengenerators 17 und damit die Plasmaimpedanz nach Abschluß des Hochfahrens der Plasmaleistung schließlich stationär, führt die Regelschaltung die Frequenz des ICP-Spulengenerators 17 bzw. des erzeugten elektromagnetischen Wechselfeldes auf den eigentlich gewünschten Festwert von beispielsweise 13,56 MHz zurück und fixiert sie dort. Für die Frequenz des stationären Leistungsfalls ist dabei der zweite Impedanztransformator 18 bereits über die zuvor ermittelte Voreinstellung, die natürlich von der zu erreichenden maximalen Plasmaleistung abhängig ist, richtig eingestellt, was entweder manuell oder automatisch - mit langsamer Regelcharakteristik - erfolgen kann.

Zusammenfassend ist die Frequenz des ICP-Spulengenerators 17 somit im stationären Fall der einzukoppelnden Leistung auf beispielsweise 13,56 MHz festgelegt, während im Laufe der instabilen Hochlaufphasen der Generatorausgangsleistung die Frequenz vorübergehend innerhalb einer gewissen Bandbreite freigegeben und durch eine Regelelektronik zur Impedanzanpassung kontrolliert wird. Es ist somit möglich, auch sehr schnelle Leistungsänderungen der Generatorausgangsleistung im Mikrosekundenbereich bei gleichzeitig hohen Leistungsänderungen stabil auszuführen, was durch bekannte Anpaßnetzwerke oder Impedanztransformatoren nicht möglich ist.

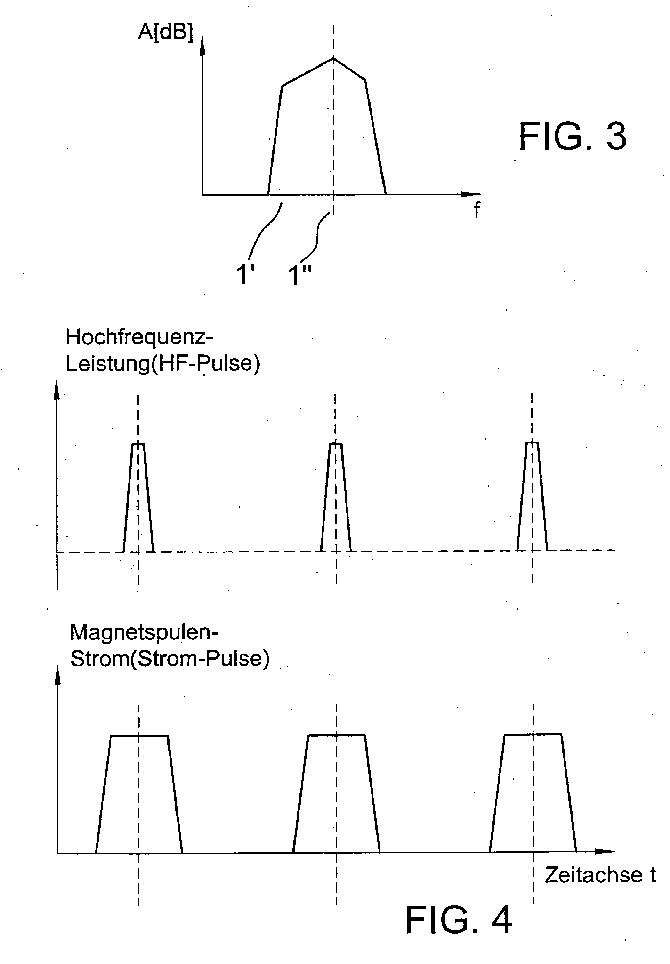

Dies wird beispielsweise mit Hilfe der Figur 3 erläutert, in der eine Filterkennlinie 1' dargestellt ist, die einen voreingestellten Frequenzbereich vorgibt, innerhalb dessen die Frequenz des ICP-Spulengenerators 17 variiert werden darf, wobei jeder Frequenz eine gewisse Hochfrequenzleistung bzw. einzukoppelnde Plasmaleistung oder eine Dämpfung A der Leistung des ICP-Spulengenerators 17 zugeordnet ist. Die zu erreichende Frequenz im stationären Leistungsfall ist dabei die Stationärfrequenz 1", die beispielsweise 13,56 MHz beträgt, und bei der die vorgegebenen Maximalleistung als Plasmaleistung in das induktiv gekoppelte Plasma 14 eingespeist wird.

Ein besonders bevorzugtes weiteres Ausführungsbeispiel der Erfindung sieht in Weiterführung des vorstehend erläuterten Ausführungsbeispiels weiter vor, die Frequenzvariation des ICP-Spulengenerators 17 einem selbsttätig wirkenden Rückkopplungskreis zu überlassen, so daß auf die Messung der jeweiligen Fehlanpassung oder des reflektierten Signals beispielsweise über Reflektometer verzichtet werden kann. Dies wird anhand der Figur 2 näher erläutert.

Die ICP-Quelle 13 d.h. konkret deren Spule wird dabei zunächst in an sich aus DE 199 00 179 bekannter Weise durch ein vorzugsweise balanciertes symmetrisches Anpaßnetzwerk 2 aus einem unbalancierten unsymmetrischen Ausgang des ICP-Spulengenerators 17 gespeist. Das Anpaßnetzwerk 2 ist Teil des zweiten Impedanztransformators 18.

Der ICP-Spulengenerator 17 besteht weiter in diesem Fall in einer weit verbreiteten Ausführungsform aus einem Hochfrequenz-Leistungsverstärker 3 und einem Quarzoszillator 4 zur Erzeugung einer hochfrequenten Grundschwingung mit fester Frequenz von beispielsweise 13,56 MHz.

Die hochfrequente Grundschwingung des Quarzoszillators 4 wird im Stand der Technik normalerweise in den Verstärkereingang des Leistungsverstärkers 3 eingespeist. Erfindungsgemäß wird diese Einspeisung jedoch dahingehend modifiziert, daß der Quarzoszillator 4 vom Verstärkereingang des Leistungsverstärkers 3 getrennt und dessen Eingang extern, beispielsweise über eine entsprechende Eingangsbuchse, zugänglich gemacht wird. Da der Quarzoszillator in dieser Ausführungsform keine Funktion mehr besitzt, kann er auch geeignet deaktiviert werden.

Der Leistungsverstärker 3 besitzt weiter in bekannter Weise Generatorsteuereingänge 9, die zur externen Steuerung des ICP-Spulengenerators 17 dienen. Darüber ist beispielsweise ein Ein- und Ausschalten des ICP-Spulengenerators 17 oder die Vorgabe einer zu erzeugenden Hochfrequenzleistung möglich. Außerdem sind Generatorstatusausgänge 9' zur Rückmeldung von Generatordaten wie beispielsweise Generatorstatus, gegenwärtige Ausgangsleistung, reflektierte Leistung, Überlast usw. an ein nicht dargestelltes externes Steuergerät (Maschinensteuerung) oder die Stromversorgungseinheit 23 der Plasmaätzanlage 5 möglich.

Der Verstärkereingang des Leistungsverstärkers 3 wird nun im Sinne einer Rückkopplungsschaltung über ein frequenzselektives Bauteil 1 mit der ICP-Quelle 13 geeignet verbunden.

Dabei können zusätzlich Kondensatoren, Induktivitäten und Widerstände oder Kombinationen aus derselben in an sich bekannter Weise als Spannungsteiler verschaltet und vorgesehen sein, um die hohen Spannungen, die an der Spule der ICP-Quelle 13 auftreten, auf ein als Eingangsgröße für das frequenzselektive Bauteil 1 bzw. den Verstärkereingang des Leistungsverstärkers 3 geeignetes Maß abzuschwächen. Solche Spannungsteiler sind Stand der Technik und sind in der Figur 2 lediglich durch einen Auskoppelkondensator 24 zwischen der Spule der ICP-Quelle 13 und dem frequenzselektivem Bauteil 1 angedeutet. Man kann den Signalabgriff 25 alternativ auch in die Nähe des eingezeichneten geerdeten Mittelpunkts oder Mittelabgriffes 26 der Spule der ICP-Quelle 13 verlegen, wo entsprechend geringere Spannungspegel herrschen. Je nach Abstand des Signalabgriffs, der beispielsweise als verstellbarer Klemmkontakt ausgeführt sein kann, vom geerdeten Mittelabgriff 26 der Spule der ICP-Quelle 13 kann eine größere oder kleinere abgegriffene Spannung eingestellt werden und somit günstige Pegelverhältnisse erreicht werden.

Das frequenzselektive Bauteil 1 ist exemplarisch als abstimmbare Anordnung von Spulen und Kondensatoren, sogenannten LC-Resonanzkreisen dargestellt, welche zusammen ein Bandfilter bilden. Dieses Bandfilter hat als Durchlaßbereich eine gewisse vorgegebene Bandbreite von beispielsweise 0,1 MHz bis 4 MHz und eine Filterkennlinie 1', wie sie exemplarisch in Figur 3 dargestellt ist.

Insbesondere weist das Bandfilter eine Resonanz- oder Stationärfrequenz 1" mit maximaler Signaltransmission auf. Diese Stationärfrequenz 1" beträgt bevorzugt 13,56 MHz und kann beispielsweise durch einen Schwingquarz 6 oder ein Piezokeramikfilterelement als zusätzlicher Komponente des Bandfilters exakt festgelegt werden.

Es ist alternativ auch möglich, anstelle von LC-Resonanzkreisen sogenannte piezokeramische Filterelemente oder andere, an sich bekannte frequenzselektive Bauelemente zu einem Bandfilter mit der gewünschten Filterkennlinie, Bandbreite und Stationärfrequenz 1" zu kombinieren.

Die vorstehend beschriebene Anordnung aus geregeltem Leistungsverstärker 3, Anpaßnetzwerk 2, ICP-Quelle 13 und Bandfilter stellt insgesamt eine Rückkopplungsschaltung nach Art eines Meißnerschen Oszillators dar.

Dieser schwingt bei Betrieb zunächst in der Nähe der Stationärfrequenz 1" an, um sich auf eine vorgegebene Ausgangsleistung des Leistungsverstärkers 3 aufzuschaukeln. Die für das Anschwingen erforderliche Phasenbeziehung zwischen Generatorausgang und Signalabgriff 25 wird dazu vorher einmalig, beispielsweise über eine Verzögerungsleitung 7 definierter Länge und damit über die durch die Signallaufzeit definierte Phasenverschiebung oder einen an sich bekannten Phasenschieber anstelle der Verzögerungsleitung 7 richtig eingestellt. Damit ist gewährleistet, daß die Spule der ICP-Quelle 13 mit einer korrekten Phase optimal entdämpft wird.

Über die Verzögerungsleitung 7 wird weiter insbesondere sichergestellt, daß am Ort der ICP-Quelle 13 die antreibende elektrische Spannung und der Strom in der Spule der ICP-Quelle 13 eine Resonanzphase von ungefähr 90° zueinander aufweisen.

In der Praxis ist im übrigen die Resonanzbedingung der Rückkopplungsschaltung über das frequenzselektive Bauteil 1 nicht scharf, so daß im allgemeinen eine geringe Frequenzverschiebung in der Umgebung der Resonanz- oder Stationärfrequenz 1" ausreicht, um die Resonanzbedingung hinsichtlich der Phase quasi selbsttätig richtigzustellen. Daher ist es ausreichend, die Resonanzbedingung durch die äußere Beschaltung nur ungefähr richtigzustellen, damit der Resonanzkreis irgendwo dicht bei seiner Stationärfrequenz 1" aufschwingt.

Sollten sich jedoch alle Phasenverschiebungen vom Signalabgriff 25 der Spule der ICP-Quelle 13 über das Bandfilter in den Eingang des Leistungsverstärkers 3 und durch den Leistungsverstärker zum zweiten Impedanztransformator 18 zurück in die Spule der ICP-Quelle 13 so ungünstig aufsummieren, daß gerade eine Bedämpfung statt einer Entdämpfung des Resonanzkreises stattfindet, so kann das System nicht anschwingen. Die Rückkopplung wird dann zu einer unerwünschten Gegenkopplung anstelle der gewünschten Mitkopplung. Die Einstellung dieser zumindest näherungsweise korrekten Phase leistet die Verzögerungsleitung 7, deren Länge daher einmalig so einzustellen ist, daß die Rückkopplung konstruktiv, also entdämpfend wirkt.

Insgesamt kann im Fall einer Fehlanpassung an die Plasmaimpedanz, beispielsweise während schneller Leistungsänderungen, der erläuterte Rückkopplungskreis innerhalb der Durchlaßbereiches des Bandfilters in seiner Frequenz somit ausweichen und eine weitgehend optimale Impedanzanpassung auch bei schnellen Impedanzänderungen des induktiv gekoppelten Plasmas 14 stets aufrechterhalten.

Sobald sich das induktiv gekoppelte Plasma 14 dann hinsichtlich der Plasmaimpedanz bzw. der eingekoppelten Plasmaleistung stabilisiert, wird die Frequenz des ICP-Spulengenerators 17 dann wieder in die Nähe oder auf den Wert der maximalen Durchlaßfrequenz zurückkehren, die durch die Resonanzfrequenz oder Stationärfrequenz 1" gegeben ist. Diese Anpassung der Impedanz durch Frequenzvariation geschieht selbsttätig und sehr schnell innerhalb weniger Schwingungsperioden der hochfrequenten Spannung d.h. im Mikrosekundenbereich.

Die Verbindung zwischen dem Ausgang des Leistungsverstärkers 3 und dem Eingang des zweiten Impedanztransformators 18 leistet im übrigen die Leitung 8, die als Koaxialkabel ausgebildet ist und in der Lage ist, eine Leistung von einigen kWatt zu tragen.

Es ist mit dieser sich selbsttätig einschwingenden Anordnung oder auch der zuvor beschriebenen Anordnung mit aktiver Frequenzregelung zur Anpassung an sich rasch verändernde Plasmaimpedanzen vorteilhaft möglich, auch einen gepulsten Betrieb der induktiven Plasmaquelle durchzuführen.

Mit der erläuterten Ausgestaltung des ICP-Spulengenerators ist es nun vorteilhaft möglich, auch einen gepulsten Betrieb der ICP-Quelle 13 durchzuführen und damit beispielsweise auch eine innerhalb der Ätz- und/oder Passivierschritte des Ätzverfahrens pulsierende Plasmaleistung einzukoppeln.

Dazu wird die Ausgangsleistung des ICP-Spulengenerators 17 beispielsweise periodisch mit einer Wiederholfrequenz von typischerweise 10 Hz bis 1 MHz, bevorzugt 10 kHz bis 100 kHz ein- und ausgeschaltet d.h. gepulst oder die Hüllkurve der Ausgangsspannung des ICP-Spulengenerators 17 mit einer geeigneten Modulationsspannung in ihrer Amplitude moduliert. Derartige Vorrichtungen zur Amplitudenmodulation sind aus der Hochfrequenztechnik hinlänglich bekannt.

Beispielsweise kann der Generatorsteuereingang 9 zur Sollwertvorgabe der Hochfrequenzleistung des ICP-Spulengenerators 17 dazu verwendet werden, um das die Hochfrequenzleistung des ICP-Spulengenerators 17 modulierende Signal einzuspeisen.

Da bei einem gepulsten Betrieb der ICP-Quelle 13 sehr schnelle Impedanzänderungen im Plasma 14 auftreten, ist es nach dem bisherigen Stand der Technik insbesondere bei Leistungen im kWatt-Bereich unmöglich, das Auftreten hoher relektierter Leistung beim Ein- und Ausschalten der eingekoppelten Hochfrequenzleistungspulse zu vermeiden oder diese zumindest unschädlich zu machen.

Durch die in diesem Ausführungsbeispiel erläuterte Vorrichtung ist dagegen auch in diesem Fall die Impedanzanpassung von induktiv gekoppeltem Plasma 14 bzw. ICP-Quelle 13 und ICP-Spulengenerator 17 jederzeit sichergestellt.

Ein gepulster Betrieb der ICP-Quelle 13 hat gegenüber einem kontinuierlichen Betrieb weiter den Vorteil, daß während der Hochfrequenzleistungspulse bzw. Plasmaleistungspulse eine wesentlich höhere Plasmadichte erreicht werden kann als bei einem kontinuierlichen Betrieb. Dies beruht darauf, daß die Erzeugung eines induktiven Plasmas ein hochgradig nichtlinearer Vorgang ist, so daß die mittlere Plasmadichte in diesem gepulsten Betriebsmodus höher ist als bei einer dem Zeitmittel entsprechenden mittleren Plasmaleistung.

Man erhält daher, bezogen auf das Zeitmittel, im Pulsbetrieb effektiv mehr reaktive Spezies und Ionen als im Dauerbetrieb. Dies gilt insbesondere dann, wenn sogenannte "Riesenimpulse" eingesetzt werden, d.h. relativ kurze und extrem leistungsstarke Hochfrequenzleistungsimpulse von beispielsweise 20 kWatt Spitzenleistung, wie dies mit der erfindungsgemäßen Vorrichtung nunmehr möglich ist, wobei die mittlere Plasmaleistung im Zeitmittel dann beispielsweise bei lediglich 500 Watt liegt.

Dabei sind dann unvermeidbare Wärmeverluste im ICP-Spulengenerator 17 und anderen Anlagenkomponenten der Plasmaätzanlage 5 mit dem relativ niedrigen Zeitmittelwert der Plasmaleistung korreliert, während erwünschte Plasmaeffekte, insbesondere die erzielbaren Ätzraten, vorteilhaft mit den auftretenden Spitzenleistungen korrelieren. Infolgedessen wird die Effizienz der Erzeugung reaktiver Spezies und Ionen deutlich verbessert.

Selbstverständlich müssen dabei der ICP-Spulengenerator 17 und die übrigen betroffenen Komponenten der Plasmaätzanlage 5 so ausgelegt werden, daß sie auch die auftretenden Spitzenbelastungen (Strom- und Spannungsspitzen) ohne Schaden verarbeiten können. Wegen der hohen Spannungsspitzen an der induktiven Spule wirkt sich hierbei die balancierte Speisung der ICP-Spule besonders vorteilhaft auf den Erhalt günstiger Plasmaeigenschaften aus.

Ein weiterer wesentlicher Vorteil eines gepulsten Betriebs der ICP-Quelle 13 ist, daß sich in den Pausen zwischen den Hochfrequenzleistungspulsen störende elektrische Aufladungen auf dem zu ätzenden Substrat 10 entladen können und damit die Profilkontrolle beim Ätzen insgesamt verbessert wird.

Typische Puls-zu-Pause-Verhältnisse liegen im übrigen zwischen 1:1 und 1:100 wobei die mittlere Plasmaleistung typischerweise 100 Watt bis 1000 Watt beträgt. Die Amplitude der einzelnen Hochfrequenzleistungspulse liegt zweckmäßig zwischen 500 Watt und 20.000 Watt, bevorzugt bei ca. 10.000 Watt.

Das erfindungsgemäße Verfahren sieht vor, daß wie vorstehend bereits erläutert ein gepulstes induktiv gekoppeltes Plasma 14 in einer ICP-Quelle 13 mit Magnetfeldunterstützung erzeugt und dabei das über die Magnetfeldspule 21 erzeugte Magnetfeld ebenfalls gepulst wird.

Besonders bevorzugt erfolgt diese Pulsung des Magnetfeldes, die in einfacher Weise über entsprechende von der Stromversorgungseinheit 23 erzeugte Strompulse hervorgerufen wird, derart, daß das Magnetfeld nur dann erzeugt wird, wenn gleichzeitig auch ein hochfrequentes Schwingungspaket oder ein Hochfrequenzleistungspuls zur Erzeugung bzw. Einkopplung von Plasmaleistung in das induktiv gekoppelte Plasma 14 an der ICP-Quelle 13 ansteht. Solange keine Plasmaleistung eingekoppelt oder kein Plasma angeregt wird, ist in der Regel auch keine Magnetfeldunterstützung erforderlich.

Eine zeitliche Synchronisation von Hochfrequenzleistungspulsen zur Einkopplung von Plasmaleistung in das Plasma 14 und der Strompulse durch die Magnetfeldspule 21 wird dabei mit Hilfe der Figur 4 erläutert.

Dabei wird der Spulenstrom durch die Magnetfeldspule 21 jeweils kurz vor dem Anlegen eines hochfrequenten Schwingungspakets d.h. eines Hochfrequenzleistungspulses eingeschaltet und kurz nach dem Ende dieses Pulses wieder ausgeschaltet.

Die zeitliche Synchronisation der Strom- bzw. Hochfrequenzleistungspulse kann dabei in einfacher Weise durch einen beispielsweise in die Stromversorgungseinheit 23 integrierten, an sich bekannten Pulsgeber gewährleistet werden, der mit zusätzlichen Zeitgliedern versehen ist, um den Hochfrequenzleistungspuls mit einer gewissen Verzögerung von beispielsweise 10 % der eingestellten Hochfrequenzimpulsdauer nach dem Einschalten des Stroms der Magnetfeldspule 21 aufzuschalten bzw. diesen Strom mit einer gewissen Verzögerung von beispielsweise 10 % der eingestellten Hochfrequenzimpulsdauer nach dem Ende des Hochfrequenzleistungspulses wieder auszuschalten. Solche Synchronisationsschaltungen und entsprechenden Zeitglieder zur Herstellung der benötigten Zeitverzögerungen sind Stand der Technik und allgemein bekannt. Dazu ist die Stromversorgungseinheit 23 weiter mit dem ICP-Spulengenerator 17 in Verbindung.

Die zeitliche Synchronisation der Pulsung von Magnetfeld und eingekoppelter Plasmaleistung hat den großen Vorteil, daß damit die in der Magnetfeldspule 21 anfallende Ohmschen Wärmeverluste deutlich reduziert werden können. Damit werden Probleme der Kühlung und Temperaturkontrolle entschärft.

Wird beispielsweise die eingekoppelte Plasmaleistung mit einem Puls-zu-Pause-Verhältnis von 1:20 betrieben, so kann auch der Strom durch die Magnetfeldspule beispielsweise mit einem Puls-zu-Pause-Verhältnis von 1:18 gepulst werden. Dabei ist die Dauer eines Strompulses durch die Magnetfeldspule 21 bevorzugt stets etwas länger als die Dauer eines Hochfrequenzleistungspulses.

Durch diese Vorgehensweise verringert sich die Wärmeabfuhr der Magnetfeldspule 21 auf 1/18 des ursprünglichen Werts. Gleichzeitig sinkt auch der Verbrauch an elektrischer Energie entsprechend.

Typische Wiederholraten oder Pulsraten orientieren sich an der Induktivität der Magnetfeldspule 21, die die Änderungsgeschwindigkeit des Spulenstroms begrenzt. Eine Wiederholrate von einigen 10 Hz bis 10 kHz ist, abhängig von deren Geometrie, für die meisten Magnetfeldsspulen 21 realistisch. Typische Puls-zu-Pause-Verhältnisse für die Hochfrequenzleistungspulse liegen zwischen 1:1 und 1:100.

In diesem Zusammenhang ist weiter sehr vorteilhaft, die aus DE 197 34 278 bekannte und bereits erläuterte Apertur unterhalb der Magnetfeldspule 21 einige cm über dem Substrat 10 oder der Substratelektrode 11, die das Substrat 10 trägt, einzusetzen.

Durch diese Apertur verbessert sich einerseits Uniformität der Ätzung über die Substratoberfläche insbesondere mit einer symmetrisch gespeisten ICP-Quelle 13 deutlich. Gleichzeitig reduziert sie auch das zeitvariable Magnetfeld - die Transienten - am Ort des Substrates 10. Dabei führen Wirbelströme in dem Aperturring der Apertur zu einer Bedämpfung der zeitvariablen Magnetfeldanteile unmittelbar vor dem Substrat 10, so daß Induktionsvorgänge auf dem Substrat 10 selbst abgeschwächt werden.

Derartige sich ändernde Magnetfelder, sogenannte Transienten, könnten an Antennenstrukturen auf dem Substrat Spannungen induzieren, die ihrerseits wieder zu Schädigungen des Substrates führen können, wenn dieses beispielsweise integrierte Schaltkreise oder insbesondere Feldeffekttransistoren aufweist.

Im übrigen sei betont, daß es weiterhin vorteilhaft ist, auch die über die Substratelektrode 11 an dem Substrat 10 anliegende Hochfrequenzleistung zu pulsen, die zur Ionenbeschleunigung von dem Subratspannungsgenerator 12 erzeugt wird. Dieses Pulsen erfolgt dann bevorzugt ebenfalls zeitlich korreliert oder synchronisiert mit der Pulsung des Magnetfeldes und/oder der Pulsung der eingekoppelten Plasmaleistung.

## Patentansprüche

1. Verfahren zum Ätzen eines Substrates (10), insbesondere eines Siliziumkörpers, in einem Reaktor (15) mittels eines induktiv gekoppelten Plasmas (14), wobei bei dem Ätzen ein zeitlich variierendes, insbesondere periodisch variierendes oder gepulstes Magnetfeld erzeugt wird, dessen Richtung zumindest näherungsweise oder überwiegend parallel zu der durch die Verbindungslinie von Substrat (10) und induktiv gekoppeltem Plasma (14) definierten Richtung ist, und das Magnetfeld derart erzeugt wird, daß es sich in den Bereich des Substrates (10) und des induktiv gekoppelten Plasmas (14) erstreckt, **dadurch gekennzeichnet, dass** eine Zeitlich variierende, insbesondere periodisch variierende oder gepulste Hochfrequenzleistung erzeugt und als Plasmaleistung in das induktiv gekoppelte Plasma (14) eingekoppelt wird,
wobei die Variation, insbesondere das Pulsen des Magnetfeldes mit der Variation, insbesondere dem Pulsen der eingekoppelten Plasmaleistung und/oder der Variation, insbesondere dem Pulsen der über einen Substratspannungsgenerator (12) in das Substrat (10) eingekoppelten Hochfrequenzleistung zeitlich korreliert oder synchronisiert wird.

2. Verfahren nach Anspruch 1, **dadurch gekennzeichnet, daß** das Magnetfeld mit einer Amplitude der Feldstärke im Inneren des Reaktors (15) zwischen 10 mTesla und 100 mTesla erzeugt wird.

3. Verfahren nach Anspruch 1, **dadurch gekennzeichnet, daß** das induktiv gekoppelte Plasma (14) mit einem hochfrequenten elektromagnetischen Wechselfeld mit einer konstanten Frequenz oder mit einer innerhalb eines Frequenzbereiches um eine Stationärfrequenz (1") variierenden Frequenz, insbesondere 13,56 MHz, erzeugt wird.

4. Verfahren nach Anspruch 1, **dadurch gekennzeichnet, daß** das Ätzen in alternierenden Ätz- und Passivierschritten erfolgt.

5. Verfahren nach Anspruch 1, **dadurch gekennzeichnet, daß** das Ätzen bei einem Prozeßdruck von 5 µbar bis 100 µbar und einer eingekoppelten mittleren Plasmaleistung von 300 Watt bis 5000 Watt erfolgt.

6. Verfahren nach Anspruch 1, **dadurch gekennzeichnet, daß** über eine Stromversorgungseinheit (23) ein gepulstes Magnetfeld erzeugt wird, dessen Amplitude der Feldstärke im Inneren des Reaktors (15) zwischen 10 mTesla und 100 mTesla liegt.

7. Verfahren nach Anspruch 6, **dadurch gekennzeichnet, daß** das Magnetfeld mit einer Frequenz von 10 Hz bis 20 kHz gepulst und ein Puls-Pause-Verhältnis von 1:1 bis 1:100 eingestellt wird.

8. Verfahren nach Anspruch 1, **dadurch gekennzeichnet, daß** zur Erzeugung der Plasmaleistung ein ICP-Spulengenerator (17) mit einer Frequenz von 10 Hz bis 1 MHz gepulst betrieben und damit eine mittlere Plasmaleistung von 300 Watt bis 5000 Watt in das induktiv gekoppelte Plasma (14) eingekoppelt wird.

9. Verfahren nach Anspruch 8, **dadurch gekennzeichnet, daß** der ICP-Spulengenerator (17) mit einem Puls-Pause-Verhältnis von 1:1 bis 1:100 betrieben wird.

10. Verfahren nach Anspruch 1, **dadurch gekennzeichnet, daß** das Pulsen der eingekoppelten Plasmaleistung von einer Veränderung der Frequenz der eingekoppelten Hochfrequenzleistung begleitet wird.

11. Verfahren nach Anspruch 10, **dadurch gekennzeichnet, daß** die Frequenzveränderung so gesteuert wird, daß die während des Pulsens in das induktiv gekoppelte Plasma (14) eingekoppelte Plasmaleistung maximal ist.

12. Verfahren nach Anspruch 10, **dadurch gekennzeichnet, daß** ein ICP-Spulengenerator (17) in Form einer selbsttätig wirkenden Rückkopplungsschaltung betrieben wird und die Frequenz der erzeugten Hochfrequenzleistung, die das eingekoppelte hochfrequente elektromagnetische Wechselfeld bildet, um eine Stationärfrequenz (1") variiert wird.

13. Verfahren nach Anspruch 1, **dadurch gekennzeichnet, daß** die Synchronisation derart erfolgt, daß vor einem Hochfrequenzleistungspuls des ICP-Spulengenerators (30) zum Einkoppeln der Plasmaleistung in das induktiv gekoppelte Plasma (14) zunächst das Magnetfeld angelegt wird, und daß das Magnetfeld erst nach dem Abklingen dieses Hochfrequenzleistungspulses wieder abgeschaltet wird.

14. Verfahren nach Anspruch 1, **dadurch gekennzeichnet, daß** das Puls-Pause-Verhältnis der Magnetfeldpulse größer als das Puls-Pause-Verhältnis der Hochfrequenzleistungspulse ist und das Magnetfeld während der Hochfrequenzleistungspulse zumindest nahezu konstant gehalten wird.

## Claims

1. Method for etching a substrate (10), in particular a silicon body, in a reactor (15) using an inductively coupled plasma (14), a temporally varying, in particular periodically varying, or pulsed magnetic field whose direction is at least approximately or predominantly parallel to the direction defined by the connecting line between the substrate (10) and the inductively coupled plasma (14) being generated during etching, and the magnetic field being generated in such a manner that it extends into the region of the substrate (10) and the inductively coupled plasma (14), **characterized in that** a temporally varying, in particular periodically varying, or pulsed radio-frequency power is generated and is injected, as plasma power, into the inductively coupled plasma (14), the variation, in particular the pulsing, of the magnetic field being temporally correlated or synchronized with the variation, in particular the pulsing, of the injected plasma power and/or with the variation, in particular the pulsing, of the radio-frequency power that is injected into the substrate (10) via a substrate voltage generator (12).

2. Method according to Claim 1, **characterized in that** the magnetic field is generated with an amplitude of the field strength inside the reactor (15) of between 10 mTesla and 100 mTesla.

3. Method according to Claim 1, **characterized in that** the inductively coupled plasma (14) is generated with a radio-frequency electromagnetic alternating field at a constant frequency or at a frequency that varies within a frequency range about a steady-state frequency (1"), in particular 13.56 MHz.

4. Method according to Claim 1, **characterized in that** etching is effected in alternating etching and passivation steps.

5. Method according to Claim 1, **characterized in that** etching is effected at a process pressure of from 5 µbar to 100 µbar and with an average injected plasma power of from 300 watts to 5000 watts.

6. Method according to Claim 1, **characterized in that** a power supply unit (23) is used to generate a pulsed magnetic field whose amplitude of the field strength inside the reactor (15) is between 10 mTesla and 100 mTesla.

7. Method according to Claim 6, **characterized in that** the magnetic field is pulsed at a frequency of from 10 Hz to 20 kHz and a duty ratio of from 1:1 to 1:100 is set.

8. Method according to Claim 1, **characterized in that**, in order to generate the plasma power, an ICP coil generator (17) is operated such that it is pulsed at a frequency of from 10 Hz to 1 MHz and an average plasma power of from 300 watts to 5000 watts is thus injected into the inductively coupled plasma (14).

9. Method according to Claim 8, **characterized in that** the ICP coil generator (17) is operated with a duty ratio of from 1:1 to 1:100.

10. Method according to Claim 1, **characterized in that** pulsing of the injected plasma power is accompanied by a change in the frequency of the injected radio-frequency power.

11. Method according to Claim 10, **characterized in that** the change in frequency is controlled in such a manner that the plasma power injected into the inductively coupled plasma (14) during pulsing is maximal.

12. Method according to Claim 10, **characterized in that** an ICP coil generator (17) is operated in the form of an independently acting feedback circuit and the frequency of the radio-frequency power which is generated and forms the injected radio-frequency electromagnetic alternating field is varied about a steady-state frequency (1").

13. Method according to Claim 1, **characterized in that** synchronization is effected in such a manner that the magnetic field is first of all applied before a radio-frequency power pulse from the ICP coil generator (30) for injecting the plasma power into the inductively coupled plasma (14), and **in that** the magnetic field is switched off again only after this radio-frequency power pulse has decayed.

14. Method according to Claim 1, **characterized in that** the duty ratio of the magnetic field pulses is greater than the duty ratio of the radio-frequency power pulses and the magnetic field is kept at least virtually constant during the radio-frequency power pulses.

## Revendications

1. Procédé de gravure d'un substrat (10) notamment d'une pièce en silicium dans un réacteur (15) par attaque au plasma à couplage inductif (14) selon lequel pour l'attaque on génère un champ magnétique variant dans le temps, notamment variant périodiquement ou pulsé dont la direction est au moins approximativement ou principalement parallèle à la direction définie par la ligne de liaison du substrat (10) et du plasma (14) à couplage inductif et on génère le champ magnétique pour qu'il s'étende dans la zone du substrat (10) et du plasma à couplage inductif (14),
**caractérisé en ce qu'**
on génère une puissance de haute fréquence variant dans le temps notamment variant périodiquement ou pulsée et on l'injecte comme puissance de plasma dans le plasma à couplage inductif (14),
la variation notamment la variation impulsionnelle du champ magnétique étant mise en corrélation dans le temps ou synchronisée sur la variation notamment la variation impulsionnelle de la puissance de plasma injecté et/ou la variation notamment la variation impulsionnelle de la puissance haute fréquence, couplée dans le substrat (10) par un générateur de tension de substrat (12).

2. Procédé selon la revendication 1,
**caractérisé en ce qu'**
on génère un champ magnétique dont l'intensité de champ dans le réacteur (15) est comprise entre 10 mTesla et 100 mTesla.

3. Procédé selon la revendication 1,
**caractérisé en ce qu'**
on génère le plasma à couplage inductif (14) par un champ alternatif électromagnétique à haute fréquence ayant une fréquence constante ou une fréquence variant dans une plage de fréquence autour d'une fréquence stationnaire (1") notamment 13,56 MHz.

4. Procédé selon la revendication 1,
**caractérisé en ce que**
la gravure se fait par une alternance d'étapes de gravure et de passivation.

5. Procédé selon la revendication 1,
**caractérisé en ce que**
la gravure se fait sous une pression de procédé de 5 µbars jusqu'à 100 µbars et une puissance de plasma, moyenne, couplée de 300 à 5000 watts.

6. Procédé selon la revendication 1,
**caractérisé en ce qu'**
on génère un champ magnétique pulsé par une unité d'alimentation électrique (23), l'amplitude de l'intensité du champ à l'intérieur du réacteur (15) étant comprise entre 10 mTesla et 100 mTesla.

7. Procédé selon la revendication 6,
**caractérisé en ce qu'**
on pulse le champ magnétique à une fréquence de 10 Hz jusqu'à 20 kHz et avec un rapport impulsion/ pause de 1/1 jusqu'à 1/100.

8. Procédé selon la revendication 1,
**caractérisé en ce qu'**
on génère la puissance plasma par un générateur à bobine de plasma à couplage inductif ICP (17) avec une fréquence de 10 Hz jusqu'à 1 MHz par un fonctionnement pulsé et on couple dans le plasma à couplage inductif (14) une puissance moyenne de plasma de 300 watts à 5000 watts.

9. Procédé selon la revendication 8,
**caractérisé en ce que**
le générateur à bobine de plasma à couplage inductif ICP (17) fonctionne avec un rapport impulsion/pause de 1 :1 jusqu'à 1 :100.

10. Procédé selon la revendication 1,
**caractérisé en ce qu'**
on accompagne les impulsions de la puissance de plasma couplée avec une variation de fréquence de la puissance à haute fréquence.

11. Procédé selon la revendication 10,
**caractérisé en ce qu'**
on commande la variation de fréquence pour que la puissance de plasma couplée pendant les impulsions dans le plasma à couplage inductif (14) soit maximale.

12. Procédé selon la revendication 10,
**caractérisé en ce qu'**
on fait fonctionner un générateur à bobine (17) sous la forme d'un circuit à réaction à fonctionnement autonome et on varie la fréquence de la puissance haute fréquence générée qui constitue le champ alternatif électromagnétique haute fréquence couplé autour d'une fréquence stationnaire (1").

13. Procédé selon la revendication 1,
**caractérisé en ce qu'**
on effectue la synchronisation en appliquant tout d'abord le champ magnétique avant l'impulsion de puissance haute fréquence du générateur à bobine de plasma à couplage inductif ICP 30 pour coupler la puissance de plasma dans le plasma à couplage inductif (14) et on ne coupe le champ magnétique qu'après l'atténuation de cette impulsion de puissance haute fréquence.

14. Procédé selon la revendication 1,
**caractérisé en ce que**
le rapport impulsion/pause de l'impulsion de champ magnétique est supérieur au rapport impulsion/pause de l'impulsion de puissance à haute fréquence et on maintient le champ magnétique au moins pratiquement constant pendant l'impulsion de puissance à haute fréquence.
